# EUROPEAN PATENT APPLICATION

(11) **EP 0 630 049 A1**
(43) Date of publication of application: **21.12.1994**
(21) Application number: 94304312.5
(22) Date of filing: 15.06.1994
(51) Int. Cl.: H01L 25/065

(54) **Semi-conductor die assembly**

(30) Priority: 16.06.1993 GB 9312382
(71) Applicant: BRITISH AEROSPACE PUBLIC LIMITED COMPANY, Farnborough, Hants. GU14 6YU (GB)
(72) Inventor: Turner, Ian Vincent, Filton, Bristol BS12 7QW (GB); Jones, Peter, Filton, Bristol BS12 7QW (GB)
(74) Representative: Potts, Susan Patricia

(57) **Abstract**

A semi-conductor die assembly comprises two naked dies (1,2) mounted "back to back" on a ceramic substrate (3). TAB bonded electrical connections (5) are made between the dies (1,2) and substrate (3). The assembly can be provided with a lid (8) and external connecting pins to form a compact, low-profile package. The invention is particularly applicable to mass memory systems and its inherent reliability makes it ideal for use in space craft and aircraft crash recorder applications.

## Description

This invention relates to the field of high density electronic circuits and particularly, to packaging semiconductor integrated circuits in applications requiring exceptionally high packing density at low cost.

At present, when there is a need to package integrated circuits so that they and their associated interconnections occupy the minimum volume, it is usual to either use the devices in unencapsulated die form in a thick or thin film hybrid or a Multi Chip Module (see for example, EP-A-383296). The integrated circuits are attached to a substrate (which may be an integral part of the package) and electrically connected to it by wire bonding, Tape Automated Bonding (TAB) or flip chip techniques. These methods do not give the degree of packing density needed in extreme applications.

Alternatively, custom die can be used in an edge stacking arrangement (see for example US 4,525,921). These have the disadvantages of necessitating the use of custom die which is both restrictive and expensive; the resulting assemblies, whilst compact, are relatively tall thus restricting the packaging efficiency at the next level of assembly. It is also a technique beyond the capability of most microelectronic packaging companies.

This invention aims to provide a low profile assembly of devices occupying an area only slightly greater than that of one device, thereby almost doubling the packing density.

Accordingly, this invention comprises a semi-conductor die assembly comprising a substrate on a surface of which is mounted a pair of naked semi-conductor dies, said dies being arranged so that their inactive faces are adjacent to one another and so that the active face of one of the dies is adjacent to said substrate surface.

The back-to-back configuration of the die pair minimises the risk of damaging their active faces during assembly.

The substrate is a means for providing interconnection between the dies and external circuitry.

The substrate area can be made large enough to accommodate further die pairs if required.

The substrate can be formed, for example from multi-layer, co-fired material. This material is essentially ceramic and may incorporate metal conducting tracks, pads and vias.

The substrate can be provided with a lid and external connecting pins to produce an integrated circuit package for connection to a printed circuit board.

Some embodiments of the invention will now be described, by way of example only, with reference to the drawings of which:

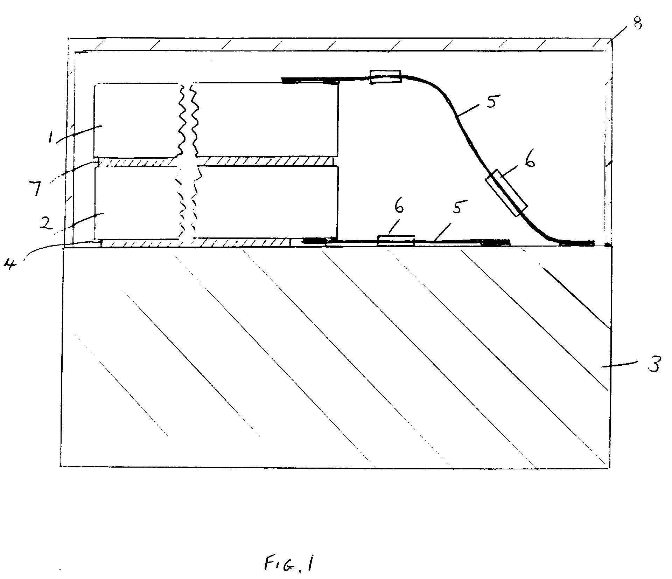

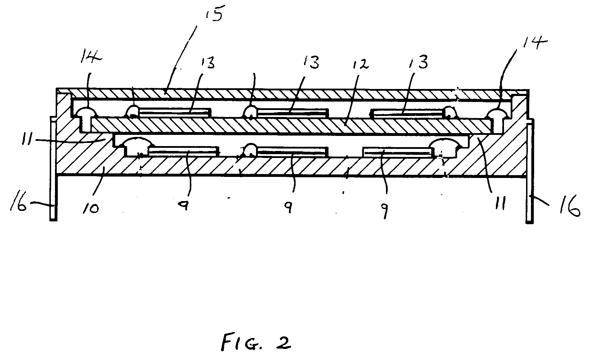

Figures 1 and 2 are cross-sectional views of two alternative integrated circuit packages in accordance with the invention.

In the embodiment of Figure 1, both a top semi-conductor die 1 and a bottom semi-conductor die 2 are inner lead bonded to TAB lead frames (not shown) prior to assembly.

The active faces of both dies are provided with a passivation coating. The bottom die 2 is then TAB bonded to a substrate 3 with its active face down and secured with a layer of adhesive 4. The back face of the upper die 1 is attached to the bottom die 2 by a layer 7 of epoxy resin, thermoplastic adhesive or similar. The active face of the top die 1 is TAB bonded (preferably) or wire bonded onto the substrate 3. Bonds can comprise gold plated copper conductors 5, re-inforced by polyimide support strips 6. The copper leads 5 are bonded to the substrate 3 preferably by thermo-compression rather than solder. This bonding method requires less processing effort and is therefore more cost effective.

This concept is most readily used with integrated circuits whose back face should be isolated from the circuit. In this instance, the adhesive layer 7 is non-conductive. Where an electrical connection is required, conductive adhesive can be used in conjunction with a third TAB lead frame (not shown) sandwiched between the two dies.

The substrate 3 with its pairs of die can then be packaged in a hybrid or multi-chip module or encapsulated directly by a sealable enclosure 8 and provided with external connecting pins (not shown).

A greater packing density can be achieved by extending the substrate area and populating it with further pairs of dies assembled as described above with reference to Figure 1.

In a further alternative embodiment, both sides of the substrate 3 are populated with die pairs and encapsulated in a sealable, box-like enclosure.

In the embodiment shown in figure 2 a plurality of semi-conductor die pairs 9 are mounted on a first substrate 10 which incorporates a shoulder 11 on which is located a second substrate 12 also populated with semi-conductor die pairs 13.

The shoulder 11 provides mechanical support for the second substrate 12 which is fixed in place with epoxy adhesive. Electrical connections between the two substrates are made using wire bonds 14.

The assembly is provided with a lid 15 and external connecting pins 16.

Further support may be given to the second substrate 12 by providing support walls (not shown) between the two substrates 10 and 12.

To facilitate pressure balancing and the back-filling of an inert atmosphere, the second substrate 12 may be provided with small holes.

In order to maximise packing density, semi-conductor die pairs can be provided on both sides of the second substrate 12.

Optionally, further sets of shoulders could be incorporated in the first substrate 10 to support further substrates.

In a further embodiment which achieves a greater packing density, two packages of the type shown in figure 2 are fixed to one another in a back-to-back configuration. The packages share common external connecting pins. The second substrate may be populated on one of its sides only, or both of its sides, depending on the packing density required.

The invention is particularly applicable to mass memory and similar building block systems, where there are many identical devices to be packaged. Also, it is applicable to very thin products such as smart cards and miniature products such as hand held or covert devices.

The inherent high reliability makes it ideal for use in Space craft memory and aircraft crash recorder applications. Furthermore, the invention can be implemented with dies supplied by most manufacturers.

## Claims

1. A semi-conductor die assembly comprising a substrate (3) on a surface of which is mounted a pair of naked semi-conductor dies (1,2), said dies being arranged so that their inactive faces are adjacent to one another and so that the active face of one of the dies (2) is adjacent to said substrate surface.

2. A semi-conductor die assembly according to claim 1 including electrical conductors (5) connected between said dies (12) and substrate (3) and secured by thermo-compression bonds.

3. A semi-conductor die assembly according to claim 2 in which the electrical conductors (5) are provided with insulating support strips (6).

4. A semi-conductor die assembly according to any preceding claim in which both sides of the substrate (3) are populated with naked semi-conductor dies (1,2).

5. A semi-conductor die assembly according to any of claims 1 to 3 in which the substrate (10) is provided with a shoulder (11) on which is supported a subsequent substrate (12) populated by at least one semi-conductor die pair (13).

6. A semi-conductor die assembly according to claim 5 in which the substrate (10) incorporates further shoulders for supporting further substrates populated by at least one semi-conductor die pair.

7. A semi-conductor die assembly comprising two assemblies according to either of claims 5 or 6 which are fixed together in a back-to-back configuration.

8. A semi-conductor die assembly according to any preceding claim which is provided with a lid (15) and external connecting pins (16).
